(19) Europäisches Patentamt
European Patent Office
Office européen des brevets

(11) Publication number: **0 204 631**
**A2**

(12) # EUROPEAN PATENT APPLICATION

(21) Application number: 86401172.1

(22) Date of filing: 03.06.86

(51) Int. Cl.[4]: **H 01 L 23/28**
H 01 L 21/312, H 01 L 23/52

(30) Priority: 04.06.85 US 740978

(43) Date of publication of application: 10.12.86 Bulletin 86/50

(84) Designated Contracting States: DE FR GB IT NL

(71) Applicant: FAIRCHILD SEMICONDUCTOR CORPORATION
10400 Ridgeview Court P.O. Box 1500
Cupertino California 95014(US)

(72) Inventor: Thomas, Michael E.
20718 Garden Crest Court
Cupertino California 95074(US)

(72) Inventor: Keyser, Thomas R.
1333 Worth Court, N.E.
Palm Bay Florida 32902(US)

(74) Representative: Chareyron, Lucien et al,
Schlumberger Limited Service Brevets c/o Giers 12, place des Etats Unis B.P. 121
F-92124 Montrouge Cédex(FR)

(54) **Semiconductor structures having polysiloxane leveling film.**

(57) A semiconductor structure comprising a substrate having at least one stepped topographical surface and a polysiloxane dielectric leveling layer disposed on said topographical surface. The topographical surface can include a layer of metallization as well as a layer of glass coating disposed on the metallization layer. The polysiloxane layer has good high temperature stability (450°C) and adherence to metal layers and can be readily etched using dry processing.

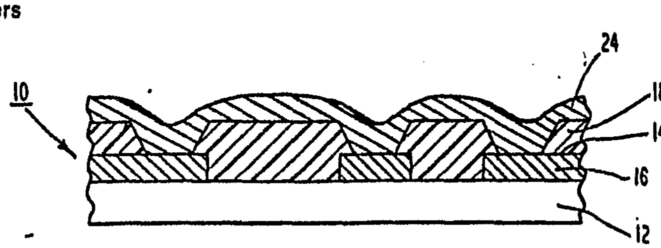


Fig. 3

EP 0 204 631 A2

# SEMICONDUCTOR STRUCTURES HAVING POLYSILOXANE LEVELING FILM

## Background of the Invention

This invention relates to methods for processing semiconductor devices and more particularly to a method for forming a substantially planar polysiloxane passivation layer over a stepped topographical surface on a semiconductor device.

While the concept of using spin-on dielectrics to provide structural leveling and electrical passivation in the semiconductor industry has been reported, the materials utilized possess properties that make them undesirable for semiconductor device applications. For example, one class of organic polymers which has been employed as a dielectric layer between metallic interconnect layers is the polyimide group, with successive polyimide layers being applied as the dielectric film between such metallic layers. In accordance with this prior technique, metal bumps were grown on metal contacts of underlying interconnect layer in order to make electrical connections to a subsequent overlying interconnect layer. A thick polyimide layer was then applied over the interconnect layer and the bumps which had been grown thereon. In order to get the planarizing desired, the applied polyimide layer was etched back with an oxygen plasma until the metal bumps were cleared of organic material.

A metal layer was then deposited over these bumps and an interconnect pattern was defined therein to form the overlying interconnect layer which electrically contacted the underlying interconnect layer through the metal bumps. This process was successively applied to yield a multiple interconnect structure.

The disadvantage inherent in the use of this material is that it possesses properties which are questionable for reliability requirements that include inhibiting water permeation through the film; blocking mobile ion transport through the film; providing good adhesion with topside passivation and metallization layers; and having negligible activity in transporting and trapping electrical charges during high frequency operation.

Another class of materials which has been used comprises spin-on glass or silicates which have been placed on wafers and used at high temperatures to inject dopants into the wafers. However, while very thin films (e.g. on the order of 2,000Å) of these materials appear to be durable, thicker films as would be necessary for topographical leveling appear to fail due to the stresses generated by contraction during curing. Thus, the polyimide and silicate films have found slow acceptance as dielectric leveling layers for semiconductor structures.

## Summary of the Invention

It is therefore an object of the present invention to provide an effective dielectric leveling layer on a stepped topographical surface of a semiconductor structure.

Another object of the invention is to provide a dielectric leveling layer which exhibits stability in high temperature semiconductor applications.

Yet another object of the invention is to provide a leveling layer which has high electrical

breakdown strengths, good adherence to silicon, silicon dioxide, and metal surfaces, and which can be readily etched using dry processing similar to silicon dioxide.

A further object of the present invention is to provide a material which is an effective moisture permeation barrier.

Still another object of the present invention is to provide a thick dielectric layer which does not undergo cracking during high temperature curing.

These and other objects which will become apparent are achieved in accordance with the present invention by applying a layer of a polysiloxane material over a stepped topographical surface of an integrated circuit device in order to form a planarized dielectric passivation layer thereover.

In one embodiment, the topographical surface comprises an electrical interconnect layer. In another embodiment, the topography comprises a conformal layer of glass coating disposed on the electrical interconnect layer. Additionally, the structure can possess a plurality of stepped topographical surfaces with each of the surfaces having a respective leveling layer of polysiloxane material disposed thereon. The leveling layer is preferably applied to the topographical surface by spin coating a polysiloxane solution thereon to a thickness of from about 0.1 micron to about 2.0 microns. After leveling layer application and curing thereof, patterns can be defined in photoresist placed over said layer. Vias can be opened through the layer to the underlying topography using either a dry etching plasma or wet chemical etchant. As desired, a second layer of metallization can then be deposited on the leveling layer and into the vias, and a subsequent leveling layer deposited on said second metallization layer. By repeating this process a plurality of layers can be achieved. Polysiloxanes of the general formula

$[R_2SiO]_n$, wherein R is chosen from the group consisting of $CH_3$ and $C_6H_5$ are preferred for formulation of the leveling layer.

## Brief Description of the Drawings

Figure 1 is a side elevation view in section of a silicon wafer having a stepped topographical surface and a dielectric leveling layer thereon.

Figure 2 is a side elevation view in section of the silicon wafer of Figure 1 illustrating vias opened to the underlying topography.

Figure 3 is a side elevation view of the silicon wafer of Figure 2 illustrating a second layer of metallization thereon.

Figure 4 is a side elevation view in section of an alternative preferred embodiment of silicon wafer having a stepped topographical surface, a glass layer, and a dielectric leveling layer thereon.

Figure 5 is a side elevation view in section of the silicon wafer of Figure 4 illustrating vias opened to the underlying metallic interconnects.

Figure 6 is a side elevation view of the silicon wafer of Figure 5 illustrating a second layer of metallization thereon.

Figure 7A through 7D depict sequential cross-sectional views of an alternate preferred method for constructing a semiconductor device in accordance with the present invention.

## Detailed Description of a Preferred Embodiment

Referring to Figure 1, there is shown a semiconductor structure 10 comprising a silicon wafer 12 having a stepped topographical surface 14 formed by topographical features 16. The features 16 can be formed of materials such as metal, oxide or silicon. For example, the features 16 could be part of a metallic interconnect layer formed on the wafer 12. A polysiloxane dielectric leveling layer 18 is formed over the topographical surface 14 as follows.

A silicone resin solution, consisting of about ten to forty percent solid by weight, is prepared. It is preferred that the solution comprise about 25% solid to 75% solvent by weight. It is also preferred that the solid be any of the family of silicone resins such as General Electric Company type SR 240 or SR 224 insulating varnish and that the solvent be toluene or butanol. The solution is then applied to the topographical surface 14 of the wafer 12. The wafer is then spun at about 5000 rpm for approximately 30 seconds to remove excess liquid, leaving a semi-dry dielectric layer 18 having a substantially planar upper surface 19 and a thickness of about 1.2 to 1.3 microns. Although layers having thicknesses in the range of 0.5 microns to 4.0 microns are preparable in accordance with the present invention, it is preferred that the thickness of layer 18 be substantially equal to approximately 1.2 microns. The structure 10 then undergoes a pre-bake cure in air at an intermediate temperature between about 90$^{o}$C and about 300$^{o}$C, preferably 270$^{o}$C, for about one hour. This pre-bake cure is performed to insure removal of most of the solvent originally present in the polysiloxane solution.

Upon completion of the pre-bake cure, the structure 10 is heated for about one hour at a temperature between about 400$^{o}$C and 500$^{o}$C in an oxygen, nitrogen or hydrogen-bearing environment to crosslink the polysiloxane and oxidize the upper surface 19 of the leveling layer 18. Note that oxidation will still occur in a nitrogen or hydrogen environment due to the presence of residual oxygen which is present in most atmospheric alloy processes. This high temperature cure enhances the adhesion of oxide forming metals, such as aluminum, for example, which can be deposited

subsequently onto the substantially level upper surface 19 of the layer 18. In this regard, it is believed that the oxidized top surface is similar to silicon dioxide which is known to strongly adhere with oxide-forming metals. The oxidized surface once formed also retards rapid oxygen diffusion at moderate temperatures around 450$^{o}$C, thereby protecting the underlying bulk of the layer 18 from progressive oxidation and subsequent degradation of the alkyl substituents in the polysiloxane. Thus, the structure 10 is quite stable.

After formation of the dielectric layer 18, having the substantially planar upper surface 19, preferably in accordance with the technique described above, vias may be formed in the dielectric layer 18 as follows. Referring to Figure 2, a layer of photoresist 20 is formed on the substantially planar upper surface 19 of the dielectric layer 18 in accordance with known techniques. The photoresist layer 20 is exposed to a predetermined via pattern, in accordance with known techniques. Via holes are then etched through the dielectric layer 18 utilizing, for example either a dry etching plasma, preferably $C_2F_6/CHF_3$ in a ratio of approximately two parts to one for times preferably between one and six minutes at a power of approximately 800 watts, or a wet chemical etchant in order to form via holes 22 therein, as shown in Figure 2. The via holes are formed through the dielectric layer 18 to expose contact areas at the appropriate locations in the metal interconnect layer 16. After the via holes 22 have been opened through the dielectric layer 18, the remaining photoresist layer 20 is removed from the upper surface 19 of the dielectric layer 18.

Figure 3 illustrates a second metallization layer 24 deposited over the leveling layer 18 after the photoresist 20 has been stripped away. In such manner, the metal of the second metallization layer 24 enters the exposed via holes 22 to make contact with the first layer metal 16. As desired, a second leveling layer can be deposited on the second metallization layer 24, and a third metallization layer can be deposited thereon in the same manner as that for said second metallization layer. As is thus evident, a plurality of respective layers can be built as desired.

In an alternative preferred embodiment, as shown in Figure 4, a semiconductor structure 40 can have a substantially conformal glass layer 42 applied to the metallization layer 16 prior to application of the leveling layer 18. The leveling layer 18 is then applied over the glass layer 42 in accordance with the procedure described above. As shown in Figure 5, via holes 44 can be opened through the leveling layer 18 and conformed glass layer 42 in accordance with conventional photolithographic etching techniques. It should be noted that one of the advantages of the formation of the leveling layer 18 in accordance with the present invention is that the layer 18 and the glass layer 42 can be etched using the same etchant.

Following the formation of the via holes 44, the photoresist layer 20 is removed from the upper surface 19 of the dielectric layer 18 and a second metallization layer 46 can then be deposited over the leveling layer 18 as shown in Figure 6. In such manner, the metal of the second metallization layer 46 enters the exposed vias 44 to make contact with the first metal layer 16 at the predefined locations. As desired, a second leveling layer or a second conformal glass

and subsequent leveling layer can be deposited on the second metallization layer 46, and a third metallization layer can then be deposited thereover in the same manner as that for the second metallization layer. Consequently, a plurality of respective layers can be built as desired.

Another alternate preferred embodiment is shown in Figure 7 wherein via posts 72 are formed at pre-determined locations on a pre-determined pattern of interconnects 74 disposed on a substrate 76. A planarized film of polysiloxane material 78 is then formed over the via posts 72 and interconnect pattern 74 in accordance with the method described hereinabove. The planarized upper surface of the polysiloxane film layer 78 is then etched back to expose the top of the via posts 72. To form a second layer of interconnects, a layer of an electrically conductive material is then formed over the planarized etched back surface of the polysiloxane film 78 and the exposed upper surfaces of the via posts 72. This metal layer 80 is then etched to form the pre-determined interconnect pattern. Additional layers of interconnects can be formed by repeating this procedure.

In addition to providing a dieletric leveling layer which exhibits stability and high temperature semiconductor applications and which has high electrical breakdown strengths, good adherence to silicon, silicon dioxide, and metal surfaces, and which provides an effective moisture permeation barrier, the present invention permits the use of a fluorine based plasma which has minimal effect on the photoresist material used to generate via holes. This is in contradistinction to organic materials, such as polyimides, for which oxygen plasma etchants must be employed. These oxygen plasma etchants react with the photoresist material thereby severely limiting the usefulness thereof.

It will be understood that various changes in the details, materials and arrangements of the parts which have been herein described and illustrated in order to explain the nature of this invention, may be made by those skilled in the art within the principles and scope of the invention as expressed in the following claims.

## Claims

What is claimed is:

1. A semiconductor structure comprising a substrate having at least one stepped topographical surface and a polysiloxane dielectric leveling layer disposed on said topographical surface.

2. The structure according to claim 1 wherein the stepped topographical surface comprises a layer of metallization.

3. The structure according to claim 2 wherein the stepped topographical surface additionally comprises a layer of conformal glass coating disposed on the metallization layer.

4. The structure according to claim 1 wherein the leveling layer has a thickness of from about 0.5 micron to about 4.0 microns.

5. The structure according to claim 4 wherein the leveling layer has a thickness of from about 0.5 micron to about 1.2 microns.

6. The structure according to claim 1 wherein the polysiloxane is of the formula

$$[R_2SiO]_n$$

wherein R is an organic side group possessing a methyl, ethyl or phenyl nature.

7. The structure according to claim 1 wherein said structure is a semiconductor wafer.

δ. The structure according to claim 1 having a plurality of stepped topographical surface each having a polysiloxane dielectric leveling layer disposed thereon.

9. A method of making a semiconductor structure, said method comprising providing a semiconductor structure having at least one stepped topographical surface, and supplying a polysiloxane dielectric leveling layer to the topographical surface of said structure.

10. The method according to claim 9 wherein the structure comprises a semiconductor wafer.

11. The method according to claim 9 wherein the step of applying the leveling layer comprises spin coating a polysiloxane solution on the topographical surface.

12. The method according to claim 11 additionally comprising the step of pre-heating the semiconductor structure at a temperature of from about $80^{o}C$ to about $325^{o}C$ subsequent to application of the leveling layer.

13. The method according to claim 12 additionally comprising the step of heating the semiconductor structure at a temperature of from about $400^{o}C$ to about $500^{o}C$ subsequent to pre-heating.

14. The method according to claim 9 wherein the leveling layer has a thickness of from about 0.5 micron to about 4.0 microns.

15. The method according to claim 14 wherein the leveling layer has a thickness of from about 0.5 micron to about 1.0 micron.

16. The method according to claim 9 wherein the polysiloxane is of the formula

$$[R_2SiO]_n$$

wherein R is an organic side group possessing a methyl, ethyl or phenyl nature.

17. The method according to claim 9 wherein the stepped topographical surface comprises a layer of metallization.

18. The method according to claim 17 additionally comprising the step of defining a resist pattern on the leveling layer and etching the leveling layer to open via holes to the layer of metallization.

19. The method according to claim 18 additionally comprising the step of depositing a second layer of metallization on the leveling layer and into the via holes to contact the first layer of metallization, and applying a second polysiloxane dielectric leveling layer to said second layer of metallization.

20. The method according to claim 19 wherein a plurality of layers of metallization are applied, each having a respective leveling layer disposed thereon.

21. The method according to claim 17 wherein the stepped topographical surface additionally comprises a layer of conformal glass coating disposed on the metallization layer.

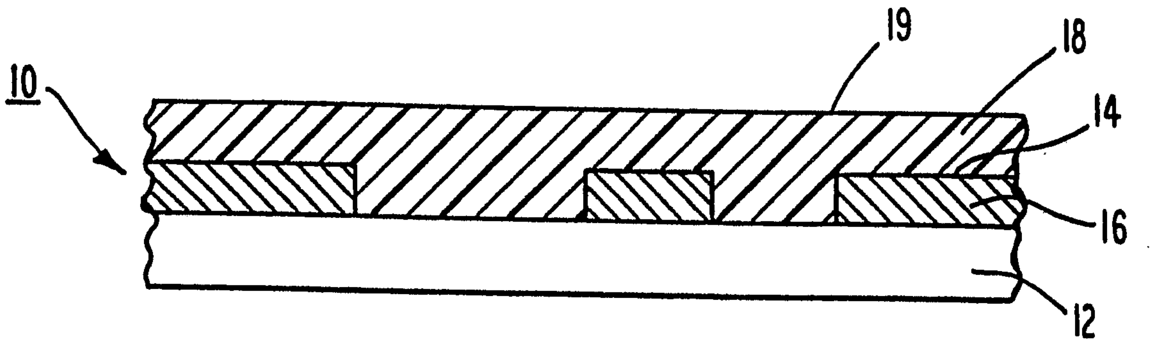


Fig. 1

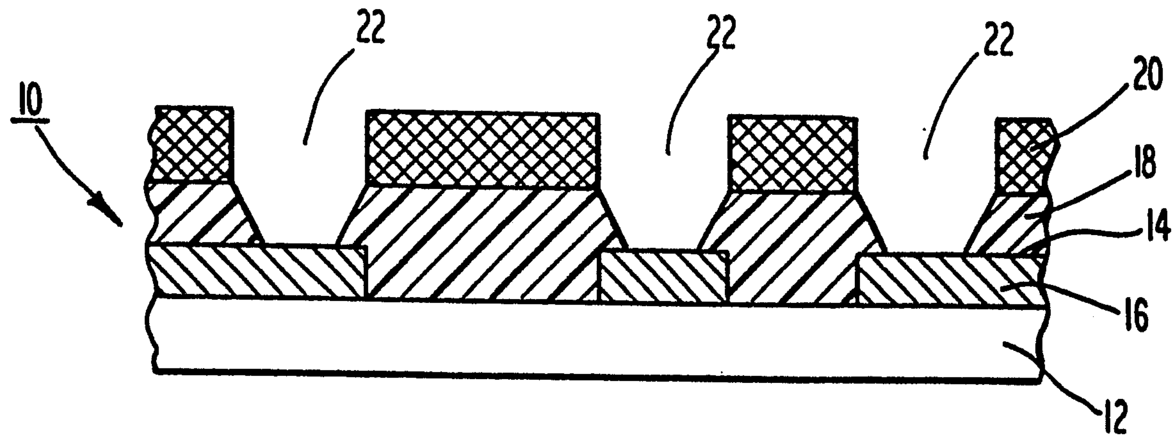


Fig. 2

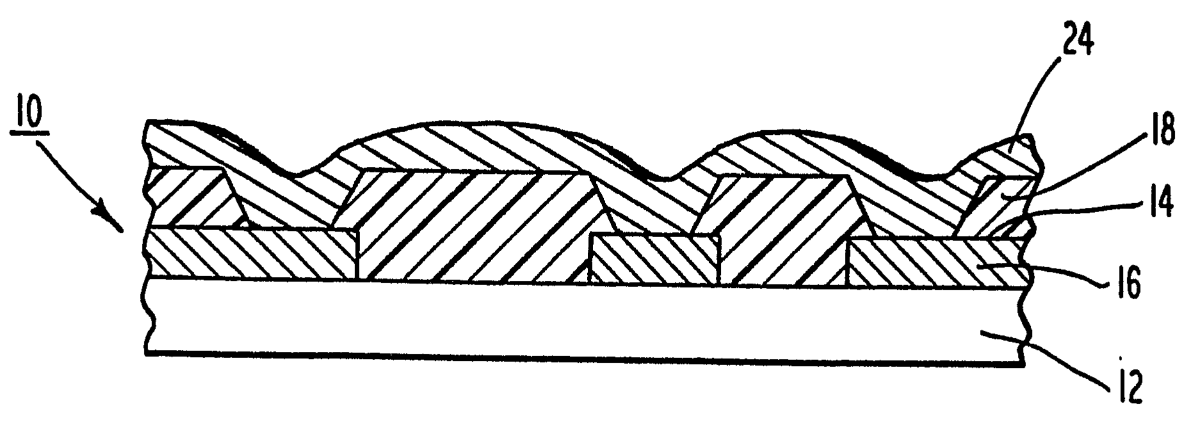


Fig. 3

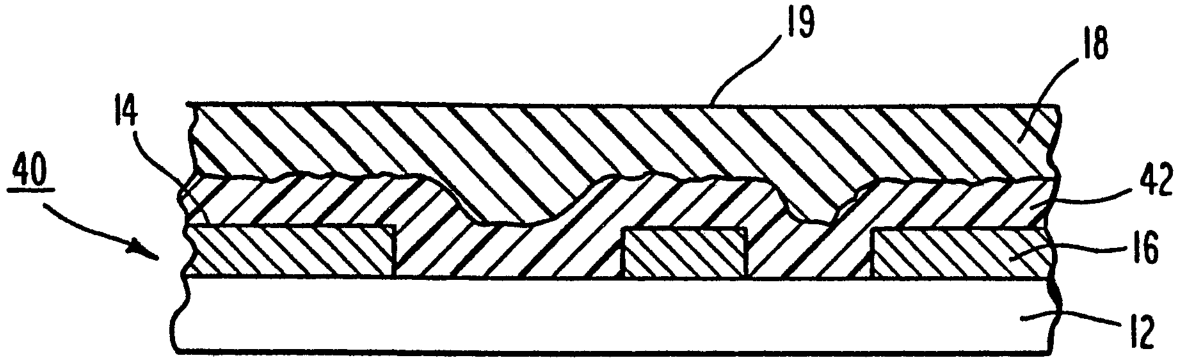


Fig. 4

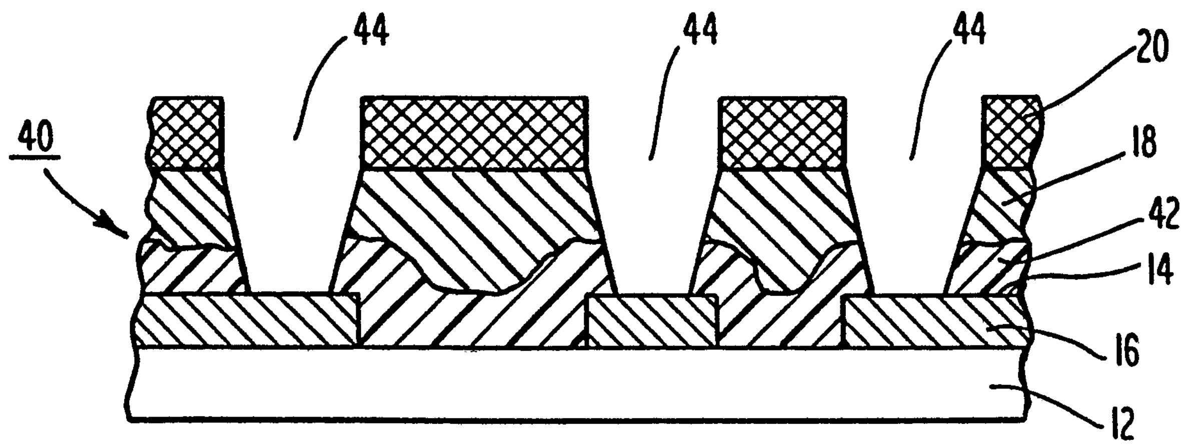


Fig. 5

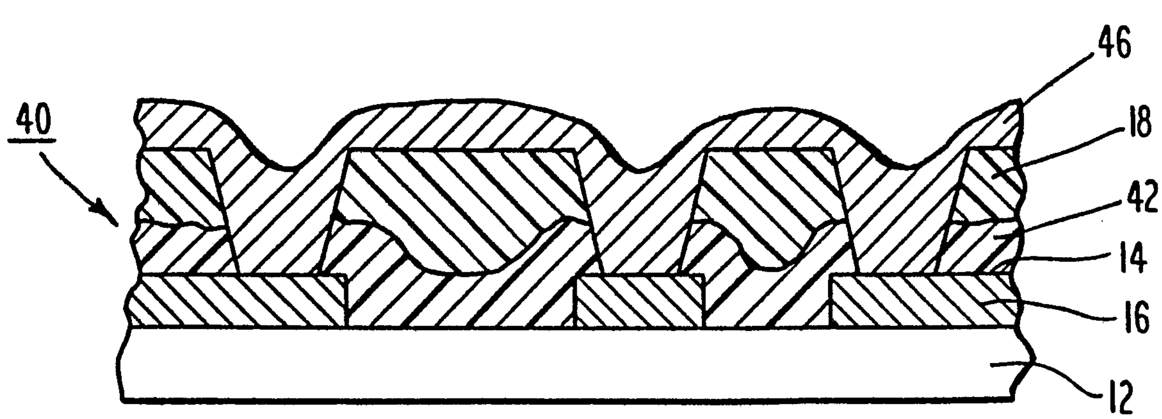


Fig. 6

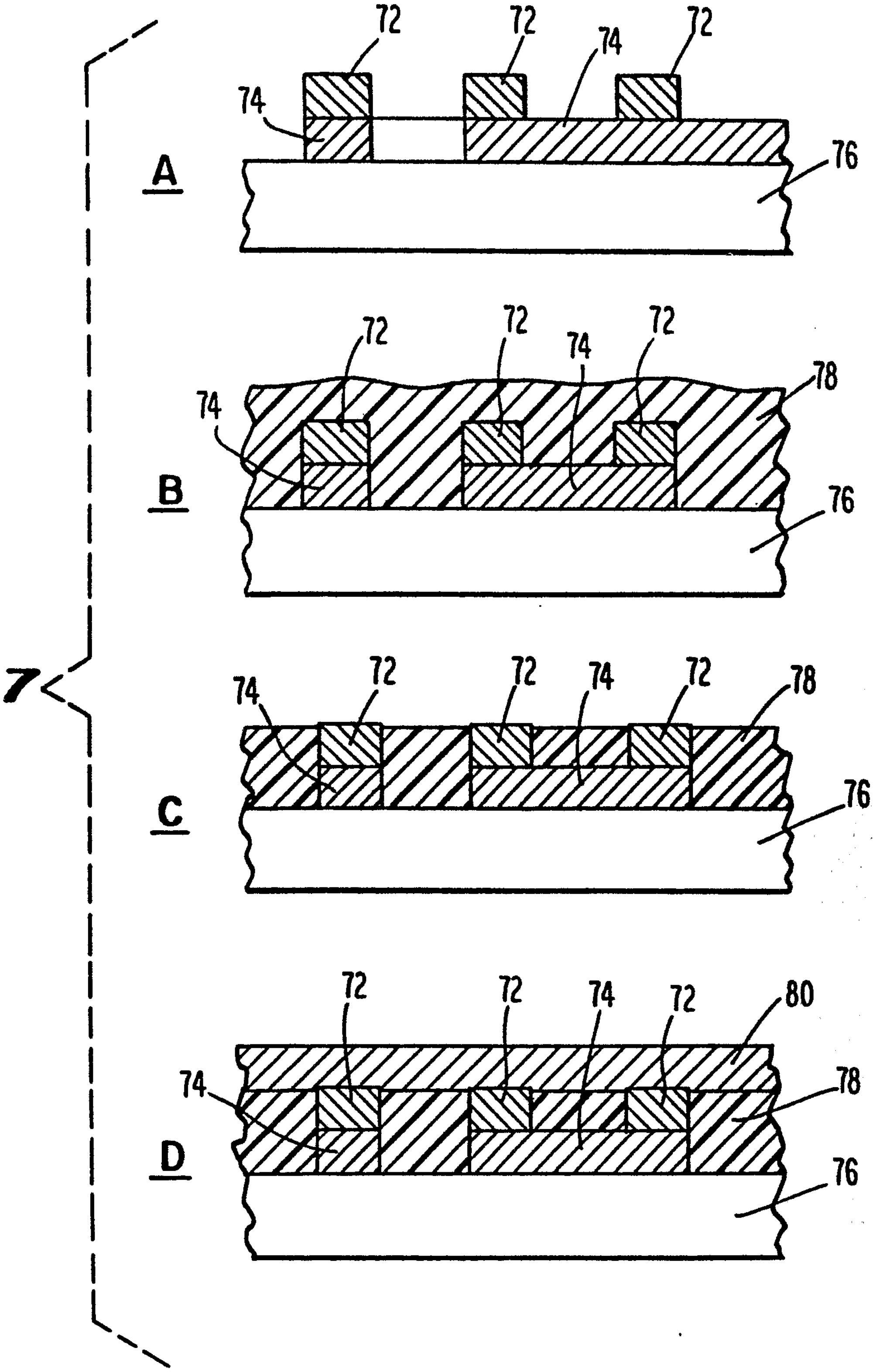
72
72
72
74
74
A
76
72
72
74
72
78
74
B
76
74
72
72
74
72
78
C
76
72
72
74
72
80
74
78
D
76

Fig. 7